# EUROPEAN PATENT APPLICATION

(11) **EP 0 964 074 A2**
(43) Date of publication of application: **15.12.1999**
(21) Application number: 99303302.6
(22) Date of filing: 28.04.1999
(51) Int. Cl.: C23C 14/48, C23C 14/54

(54) **Ion implantation control using optical emission spectroscopy**

(30) Priority: 13.05.1998 US 78129
(71) Applicant: EATON CORPORATION, Cleveland, Ohio 44114-2584 (US)
(72) Inventor: Denholm, Alec Stuart, Lincoln, Massachusetts 01773 (US); Stejic, George, Franklin, Wisconsin 53132 (US); Graf, Michael Anthony, Cambridge, Massachusetts 02138 (US)
(74) Representative: Burke, Steven David

(57) **Abstract**

Method and apparatus for use in treating a workpiece implantation surface by causing ions to impact the workpiece implantation surface. An ion source chamber (12, 220) defines a chamber interior into which a dopant material in the form of a gas is injected. A plasma of implantation material is created within the interior region of the implantation chamber. Characteristics of the ion plasma are determined from an optical analysis of the plasma using optical spectroscopy. The same ion plasma is used to supply ions used in a treatment process whereby silicon wafers (14) are doped to convert them into a semiconductor material. Data from the optical spectroscopy is stored with data from ion implantation to provide a database (280). A resulting analysis tool executing on a computer (232,274) is able to correlate additional optical spectroscopy data with one or more implantation parameters.

## Description

### Field of the Invention

The present invention concerns a workpiece treatment system that uses positively charged ions for treating a workpiece. One such system immerses one or more silicon wafers in an ion plasma having a high density of positively charged ions that are then accelerated against the surface of the wafers to implant a controlled concentration of the ions into the wafers. A second such system includes an ion source and structure for moving ions from the source to an implant station where target workpieces are situated.

### Background Art

One commercially available ion implantation system, uses an ion source that includes a source chamber spaced from an implantation chamber where one or more workpieces are treated by ions from the source. An exit opening in the source chamber allows ions to exit the source so they can be shaped, analyzed, and accelerated to form an ion beam. The ion beam is directed along an evacuated beam path to the ion implantation chamber where the ion beam strikes one or more workpieces, typically generally circular wafers. The energy of the ion beam is sufficient to cause ions which strike the wafers to penetrate those wafers in the implantation chamber. In a typical application of such a system the wafers are silicon wafers and the ions are used to "dope" the wafers to create a semiconductor material. Selective implantation with the use of masks and passivation layers allows an integrated circuit to be fabricated.

United States Patent 4,764,394 to Conrad entitled "Method and Apparatus for Plasma Source Ion Implantation" discloses an ion implantation system for treating a target by means of ionic bombardment. Ion implantation into surfaces of a three dimensional target is achieved by forming an ionized plasma about the target within an enclosing chamber. Once the plasma is set up in a region surrounding the target, ions from the plasma are driven into the target object from all sides without need to manipulate the target. This implantation is accomplished by application of repetitive pulses of high voltage, typically 20 kilovolts or higher, that cause the ions to be driven into exposed surfaces of the target. A technique discussed in the '394 patent for setting up the plasma is to introduce a neutral gas into the region of the target and then ionize the gas with ionizing radiation.

The system disclosed in the '394 patent to Conrad uses an ion source to create an ion plasma in a region surrounding a workpiece and then selectively pulses an electrode that supports the workpiece thereby attracting the positive ions in the plasma toward the workpiece.

United States patent no. 5,654,043 to Shao et al also concerns a system for treating a workpiece surface by causing ions to impact the workpiece surface. A gas is injected into an implantation chamber so that an ionizable gas occupies a region in close proximity to the workpiece surface. A plasma of implantation material is created within the interior region of the implantation chamber by repeatedly relatively biasing conductive electrodes with a sequence of pulses that both ionize the gas molecules injected into the chamber and accelerate the ionized gas molecules toward the implantation surfaces of the one or more workpieces. The disclosure of the '043 patent to Shao et al. is incorporated herein by reference.

United States patent no. 5,554,854 to Blake entitled "In Situ Removal of Contaminants from the interior Surfaces of an Ion Beam Implanter" discloses an implanter for flat panel displays. In one embodiment, a source chamber creates an ion plasma which exits from the source chamber through apertures in the source chamber to form an ion beam for treating panels within a process chamber. The disclosure of the '854 patent to Blake is incorporated herein by reference.
United States patent number 5,658,423 to Angell et al concerns a method of monitoring the status of a plasma in a chamber while conducting an etch process. Spectral analysis data is collected during etching, with the spectral data characterizing an emission of light from an etch species contained in the plasma.

### Disclosure of the Invention

The present invention concerns an ion implantation control that uses the results of an optical analysis to predict an ion implantation parameter. When used for ion implantation of a silicon wafer the process can be used to predict suitability of the implant based upon past experience under similarly experienced plasma conditions. It can also be used to adjust implant parameters to control further implantation by adjusting the plasma constituents.

An exemplary method for use in calibrating an ion implantation process includes the steps of producing a concentration of ions in an ion source chamber and performing an optical analysis of the concentration of ions and recording optical analysis data. One or more workpieces such as silicon wafers are treated by causing ions from the concentration of ions in the ion source chamber to impact the one or more workpieces. A workpiece treatment parameter is evaluated after ion treatment of said one or more workpieces. A database of records is maintained on a storage medium wherein the workpiece treatment parameter and the optical analysis data for a given concentration of ions are stored together for subsequent access. In the exemplary embodiment of the invention the parameter can be the suitability of the wafer for use in other process steps for producing an integrated circuit or could be a more exhaustive list of evaluation criteria.

These and other objects, advantages and features of the invention are described in greater detail in conjunction with the accompanying drawings.

### Brief Description of the Drawings

Figures 1 and 2 are schematic section and perspective views depicting an ion implantation system constructed in accordance with a preferred embodiment of the present invention;
Figure 3 is a schematic depiction of the physical processes that occur at an implantation surface of a workpiece;
Figures 4 and 5 are flowcharts of a process for calibrating the ion implantation system such as the system depicted in Figures 1 and 2;
Figure 6 is a schematic depiction of a low energy ion implanter;
Figure 7 is a graph showing optical emission spectra intensity as a function of wavelength for different ions and molecules present in an ion source plasma; and
Figure 8 is a graph showing predicted values of an ion implantation parameter vs. measured values for that parameter gathered during ion implantation of a silicon wafer.

### Best Mode for Practicing the Invention

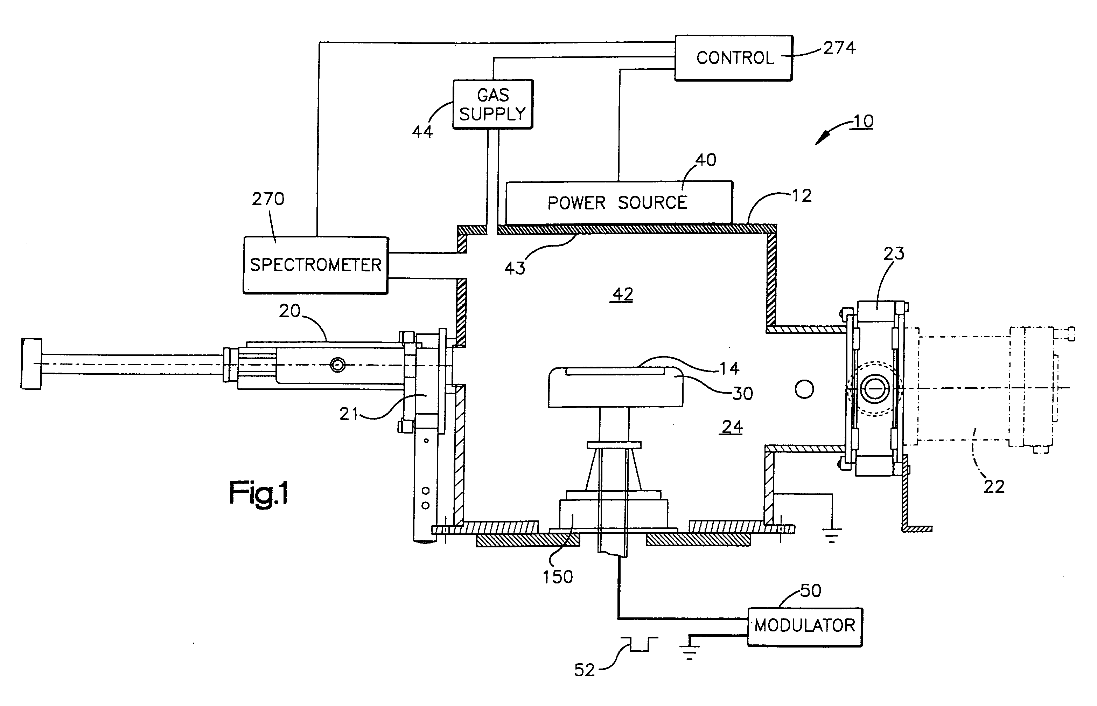

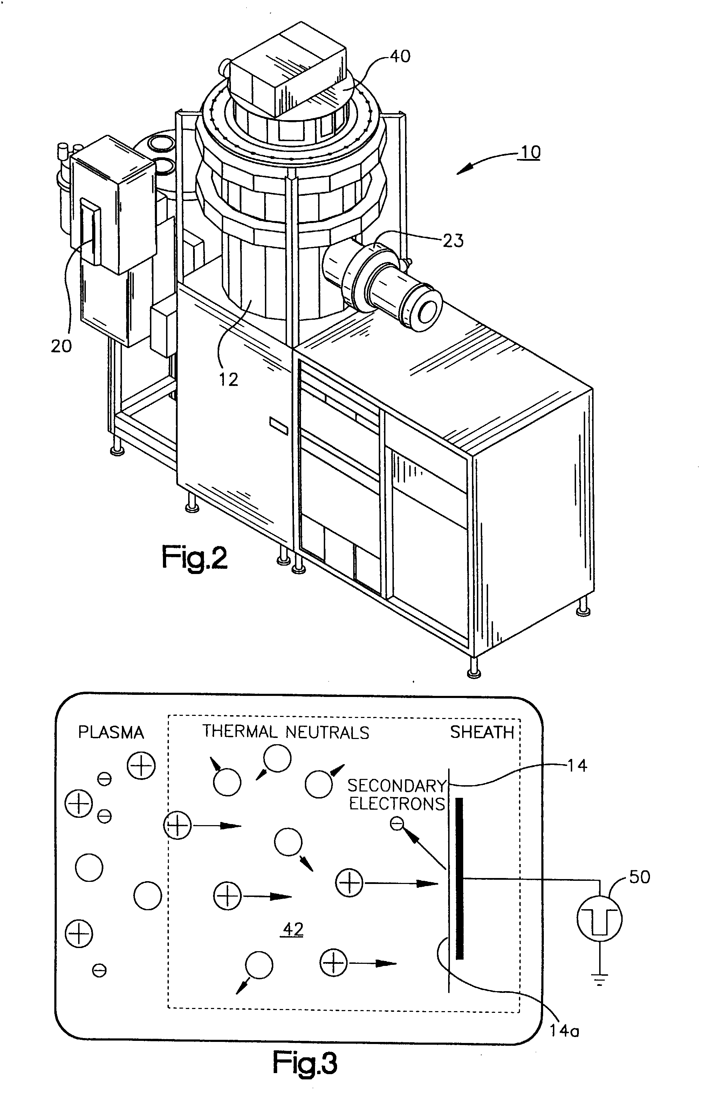

Figures 1 and 2 depict an ion implantation system 10 that includes a generally cylindrical plasma chamber 12 into which one or more generally planar workpieces 14 are inserted for ion treatment of those workpieces. The implantation system 10 includes a loadlock 20 for inserting workpieces into the plasma chamber 12. The loadlock 20 allows the plasma chamber 12 to be maintained at a reduced pressure (in relation to atmospheric pressure) as workpieces are moved into and withdrawn from the chamber 12 through a valve 21 that is opened and closed. A vacuum pump 22 maintains the chamber interior at a reduced pressure that is regulated by a valve 23 located between the chamber 12 and the pump 22.

The plasma chamber 12 depicted in Figure 1 has inner walls that define a chamber interior 24 into which the workpieces 14 are inserted. The workpieces 14 are placed onto and removed from a generally planar conductive platen or support 30. The platen 30 may have any suitable dimensions depending on the size of the workpiece it must support.

An energy source 40 is located at one end of the generally cylindrical process chamber 12. The energy source 40 injects energy into the chamber 12 to produce an ion plasma inside the plasma chamber 12 in a region 42 between the energy source 40 and the wafer support 30. One example of a suitable energy source 40 is an rf coil operating at 13.5 Megahertz that transmits rf energy through a quartz plate 43 that bounds one end of the plasma chamber 12. Other coil energization frequencies are possible and , for example, could include frequencies of about 2.0 Megahertz. Rf energy entering the chamber 12 produces an ion plasma from gas molecules that are pumped into the plasma chamber from an external gas supply 44. Representative gas pressures in the chamber 12 are maintained in the range of .2 to 5.0 millitorr. As an example, Nitrogen gas can be routed into the chamber and ionized by rf energy entering the chamber from the rf coil. Application of this energy ionizes the gas molecules. Other techniques known for producing an ion plasma in the plasma chamber could be utilized while practicing the present invention.

Once the ion plasma is set up in the region 42 between the support 30 and the quartz plate 43, the ions are accelerated into contact with the workpiece 14. In a preferred embodiment of the present invention, the workpiece is a silicon wafer, generally round in shape, that is placed onto the support 30. The workpiece support 30 is constructed from an electrically conductive material. The ions are positively charged so that application of an electric field of suitable magnitude and direction in the region of the plasma will cause the ions in the plasma to accelerate toward and impact the surface of the silicon wafers. As seen in Figure 1, a modulator 50 supplies voltage pulses 52 that relatively bias the conductive support 30 with respect to conductive inner walls of the chamber 12 to set up an appropriate electric field in the region 42.

Once the wafers 14 are treated, they are removed from the plasma chamber 12 and taken to other processing stations where the treated wafers are further fabricated to form integrated circuits. Such Ion treatment has been conducted on eight inch diameter silicon wafers with good uniformity. Ion implantation using structure similar to that shown in Figure 1 has also been used to treat large surfaces for the fabrication of flat panel displays.

Figure 3 schematically illustrates reactions occurring at a treatment surface 14a of a workpiece 14 as ions from the ion plasma region 42 strike the surface 14a. The collisions illustrated in Figure 3 give rise to both inelastic (production of photons, X-rays, secondary electrons, as well as ion implantation) and elastic (sputtering and reflected particles) reactions. An incident ion can also be trapped in a solid lattice of the workpiece 14. This is the reaction occurring at the surface that results in ion implantation of the workpiece. The ion energy directly affects the probability of implantation occurring and this in turn is mainly determined by the sheath voltage of the plasma, which is dictated by the pulse voltage supplied by the modulator 50. The trapping probability is also affected by gas pressure, since ions may lose part of their energy due to collisions with gas molecules before they reach the surface 14a.

It is difficult to monitor dose delivered by means of the pulsed ion implantation process shown in Figure 1 due to the makeup of ions in the plasma. If boron triflouride gas (BF₃) is injected into the process chamber 12 from the gas supply 44, during creation of the plasma a variety of atomic and molecular species can result. There can be singly charged boron B⁺, or BF⁺, or BF₂⁺ or atomic fluorine, F or fluorine gas, F₂, for example. For every atom impinging on the negative surface 14a of the workpiece there are several secondary electrons emitted and accelerated. Measuring the dose of a given species implanted into the workpeice 14 by total charge flow monitoring at the surface 14a is not possible because of uncertainty about secondary emission coefficients, the particle mix in the region 42 and actual negative surface area. The particle mix is a function of the electron temperature or energy of the plasma in the chamber.

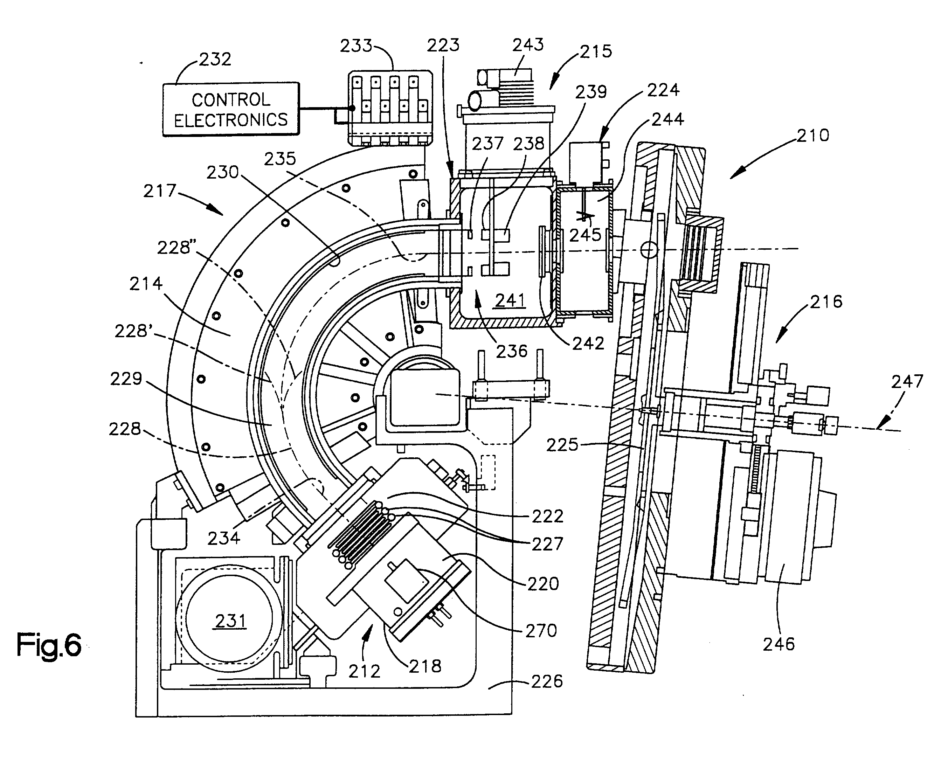

Figure 6 discloses a relatively low energy, high current ion implanter 210 wherein ions are extracted from a source to impact workpieces at a workstation. The ion implanter 210 includes an ion source 212, a mass analysis magnet 214, a beamline assembly and a target or end station 216. The ion source 212 and the mass analysis magnet 214, along with their respective power supplies, are supported within an implanter housing 217. The ion implanter 210 is a low energy implanter which operates with implant energies of a range .2 - 90 kev and supplies beam currents of about 10 milliamps. The beamline assembly 215 is relatively short due to the tendency of a low beam to diffuse (i.e. blow up) during propagation of the beam from the ion source 212 to the end station 216.

The ion source 212 comprises a housing 218 which defines a plasma chamber 220, and an ion extractor assembly 222. The beamline assembly 215 includes a resolver housing 223 and a beam neutralizer 224. The beam neutralizer 224 functions to retard beam blow-up. Downstream from the beam neutralizer 224 is the end station 216, which includes a disk-shaped wafer support 225 upon which wafers to be treated are mounted. The wafer support 225 resides in a target plane which is (generally) perpendicularly orientated to the direction of the implant beam.

The ion source 212 is mounted to an L-shaped frame 226. Ionizable dopant gas, which is obtained either directly in the form of a compressed gas or indirectly from a solid form which has been vaporized, is injected into the plasma chamber 220. Typical source elements are boron (B), phosphorous (P), galluim (Ga), Indium (In), antimony (Sb), and arsenic (As). Most of these source elements are provided in solid form, except boron, which is typically provided in the form of gaseous boron trifluoride or diborane.

Energy is transferred to the ionizable dopant gas to generate ions within the plasma chamber 220. Generally, positive ions are generated, although the present invention is applicable to systems wherein negative ions are generated by the source. The positive ions are extracted through a slit in the plasma chamber 220 by the ion extractor assembly 222 which comprises a plurality of electrodes 227. The electrodes are charged with negative potential voltages, increasing in magnitude as the distance from the plasma chamber slit increases. Accordingly, the ion extractor assembly functions to extract a beam 228 of positive ions from the plasma chamber and accelerate the extracted ions into the mass analysis magnet 214 which is supported by the frame 226.

The mass analysis magnet 214 functions to pass only ions of an appropriate charge-to-mass ratio to the resolver housing 223. The mass analysis magnet 214 is required because the ion source 212, in addition to generating ions of appropriate charge-to-mass ratio, also generates ions of greater or lesser charge-to-mass ratio than that desired.

The mass analysis magnet 214 bounds a curved beam path 229 which is defined by an aluminum beam guide 230, evacuation of which is provided by a vacuum pump 231. The ion beam 228 which propagates along this path is affected by the magnetic field generated by the mass analysis magnet 214. The strength and orientation of this magnetic field is controlled by control electronics 232 which adjusts the electrical current through the field windings of the magnet 214 through magnet connector 233. Partial focusing of the ion beam by the magnet 214 is achieved in the "dispersive " plane (the plane of the curved beam path 229) only by establishing a gradient in the magnetic field (i.e. "Indexing"), or by rotating the entrance or exit poles of the magnet 214.

The magnetic field causes the ion beam 228 to move along the curved beam path 229, from a first or entrance trajectory 234 near the ion source 212 to a second or exit trajectory 235 near the resolving housing 223. Portions 228' and 228" of the beam 228 comprised of ions having an inappropriate charge-to-mass ratio are deflected away from the curved trajectory and into the walls of an aluminum beam guide 230. In this manner, the magnet 214 passes to the resolving housing 223 only those ions in the beam 228 which have the desired charge-to-mass ratio.

The entrance and exit trajectories 234, 235 of the ion beam 228, being in the plane of the curved beam path 229, lie in the dispersive plane. The 'non-dispersive' plane is defined herein as the plane which resides perpendicular to both the dispersive plane and the target plane. Accordingly, the magnet 214 performs mass analysis in the dispersive plane by removing from the beam ions of inappropriate charge-to-mass ratio, and redirecting the beam from the entrance trajectory 234 to the exit trajectory 235 and toward the target plane in which the wafer lies.

The resolving housing 223 contains an electrostatic lens 236, constructed according to the principles of the present invention, which mass resolves and focuses the ion beam 228 output by the magnet 214. The electrostatic lens 236 is constructed in a triple electrode (triode) configuration comprising a terminal electrode pair 237, a suppression electrode pair 238 and a ground or resolving electrode pair 239. The terminal electrode pair 237 is fixedly attached to the housing 217 and operates at the voltage thereof (positive in the acceleration mode and negative in the deceleration mode). Each of the suppression electrodes 238, like each of the pair of ground electrodes 238, is movable toward and away from each other to adjust the gap therebetween. The suppression electrode 237 operates at a negative potential and the resolving electrode 239 is at ground potential (zero volts).

The suppression and resolving electrode pairs 238, 239 are collectively referred to as the adjustable lens subassembly 240. The resolving housing 223 defines a chamber 241 in which resides the electrostatic lens 236, as well as a dosimetry indicator such as a Faraday flag 242. The chamber 241 is evacuated by a vacuum pump 243. The adjacent beam neutralizer 224 defines a second chamber 244 which includes an electron shower 245. The electron shower 45 neutralizes the positive charge which would otherwise accumulate on the target wafer as a result of being implanted by the positively charged ion beam 228.

The disc shaped wafer support 225 at the end station 216 is rotated by a motor 246. The ion beam strikes wafers mounted to the support as they move in a circular path. The end station 216 is pivotable along an axis 247 which is generally parallel to the path of the ion beam so that the target plane is adjustable about this axis. In this manner, the angle of ion implantation may be slightly modified from the normal.

### Database for Implantation process control

The two ion plasma chambers 12, 220 (Figs 1 and 6) in the implantation systems 10, 210 generate similar ion plasmas, but differ in the manner in which ions are accelerated into the workpieces. The present invention concerns an ion implantation control method and apparatus that uses an optical monitoring of ion plasma constituency to control ion implantation of a workpiece. In accordance with an exemplary embodiment of the invention, the workpieces are silicon wafers and the ion implantation process dopes the wafers with a dopant material.

An optical emission spectroscopy sensor (also commonly referred to as a spectrometer) 270 is positioned in proximity to the ion plasma to perform an optical analysis 272 of the ion plasma within the plasma chamber 12. A similar optical spectroscopy sensor 270 is positioned for monitoring the plasma within the plasma chamber 220 shown in Figure 6. Each of the ion implant systems 10, 210 utilize a stored program general purposed digital computer 274 which controls the ion implantation process. In the Figure 6 system, the control electronics 232 for the magnet can optionally be part of such a computer 274. In accordance with a preferred embodiment of the invention this computer 274 controls the implantation process and also maintains a database 280 of records gathered by optical emission spectroscopy monitoring of the plasma.

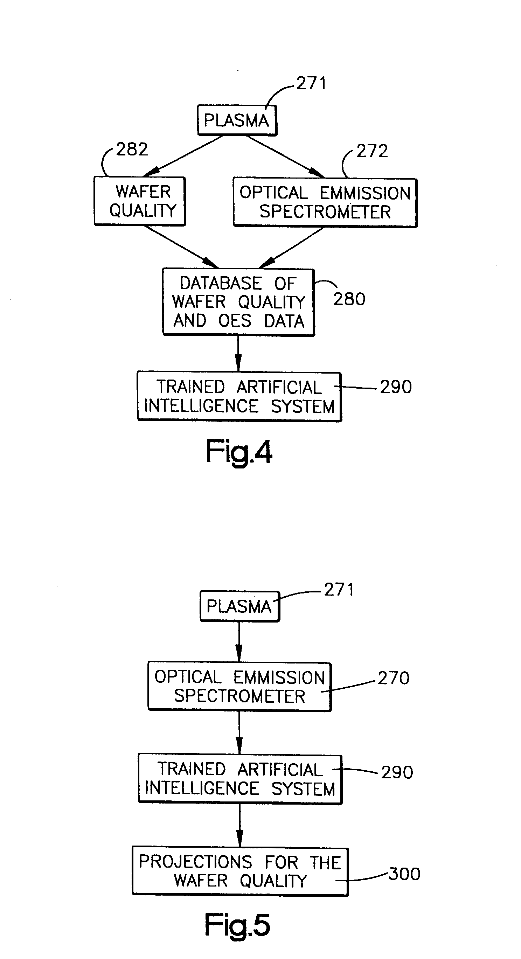

A database 280 of records is created in which an ion implantation parameter, designated wafer quality 282 in Figure 4, and the optical analysis data for plasma concentrations are stored together for subsequent access. As noted, a preferred use of the invention is in doping silicon wafers to produce semiconductor wafers used in fabricating integrated circuits such as microprocessors. One ion implantation parameter for such a process is a simple pass/fail determination of the suitability of the treated wafer for subsequent integrated circuit fabrication.

The pass/fail determination most typically will in turn be based on a number of other objective criteria which can also be stored in the database as fields or attributes of data. One such parameter is the implant uniformity as measured by resistivity across the workpiece surface. The computer 274 includes an I/O interface coupled to a mass storage device such as disk drive for storing the database 280. A combination of computer programs including artificial intelligence software 290 executing on the computer 274 uses the data on the database 280 to predict implantation parameters based on the observed data. In accordance with one aspect of the invention, the computer 274 also executes artificial intelligence software to control at least one parameter of the ion implantation process of the Figure 1 system 10 or alternately can be used to control a process such as the process described in conjunction with Figure 6.

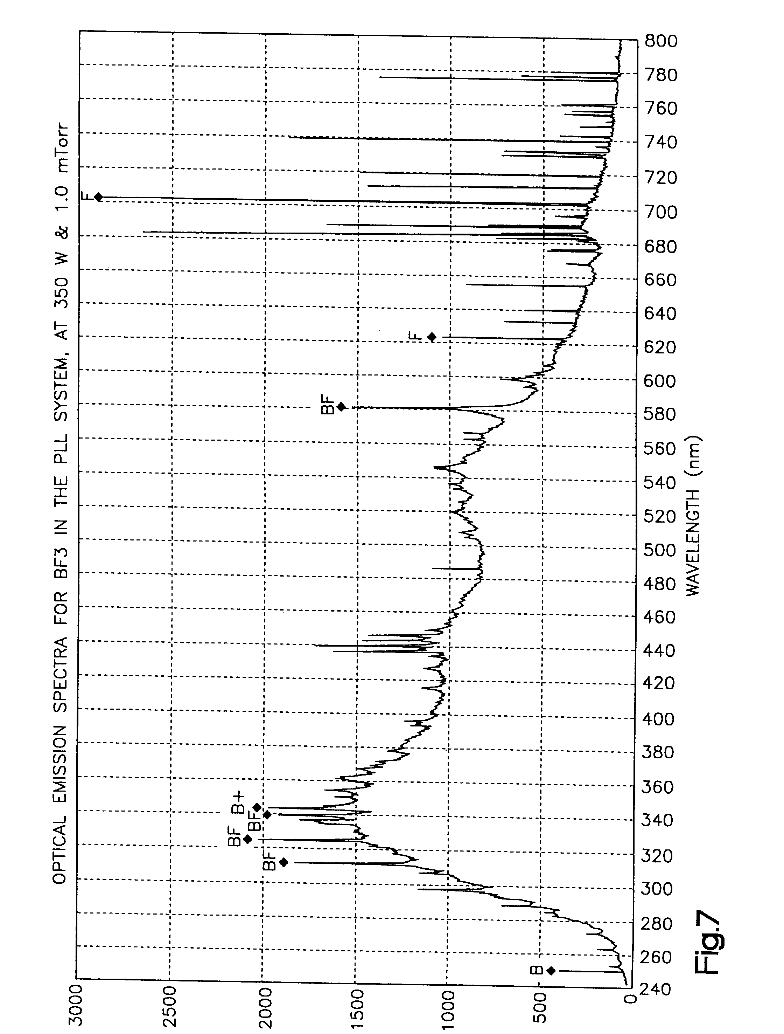

Figure 7 is a graph for an optical emission of BF₃ plasma (gas concentration fixed) from the optical spectrometer 270. A number of peaks have been labeled with the constituent particle that produced those peaks. These peaks are derived from readily identified wavelength data gathered from optical spectroscopy information tabulated by others. The 311 nanometer peak, for example, is a well known spectral peak for a neutrally charged BF molecule. Note, the data on the graph of Figure 7 is based on a specific starting gas (boron tri-fluoride) of a specified pressure and specified power input to the plasma. Changing the gas concentration produces a different characteristic curve of constituents and hence the data of Figure 7 changes.

In a preferred data gathering step 272 the entire optical analysis over the wavelengths shown in Figure 7 is stored in the database 280. Different gas pressures and different rf powers inputs create different optical emission spectra and this data can also be stored on the database 280.

As the optical emission spectroscopy data is being gathered, wafers are implanted. In the system of Figure 1 the wafers are placed into the plasma chamber 12 and in the system of Figure 6 the wafers are bombarded by ions moving in an ion beam. These wafers are production wafers used to fabricate integrated circuits. Over time a large database of records is prepared in which optical emission data and wafer quality data are stored together.

An exemplary embodiment of the invention uses learning algorithms associated with artificial intelligence or neural network software. The process involves the comparisons of data points from the optical analysis with optical analysis of the database that has been previously obtained along with the wafer implant data. By means of a neural network training and the use of the trained algorithm the computer is able to predict a wafer parameter from the real time sensed optical emission spectral data from the ion plasma chamber and can use the prediction to make changes to the plasma as wafers are being treated.

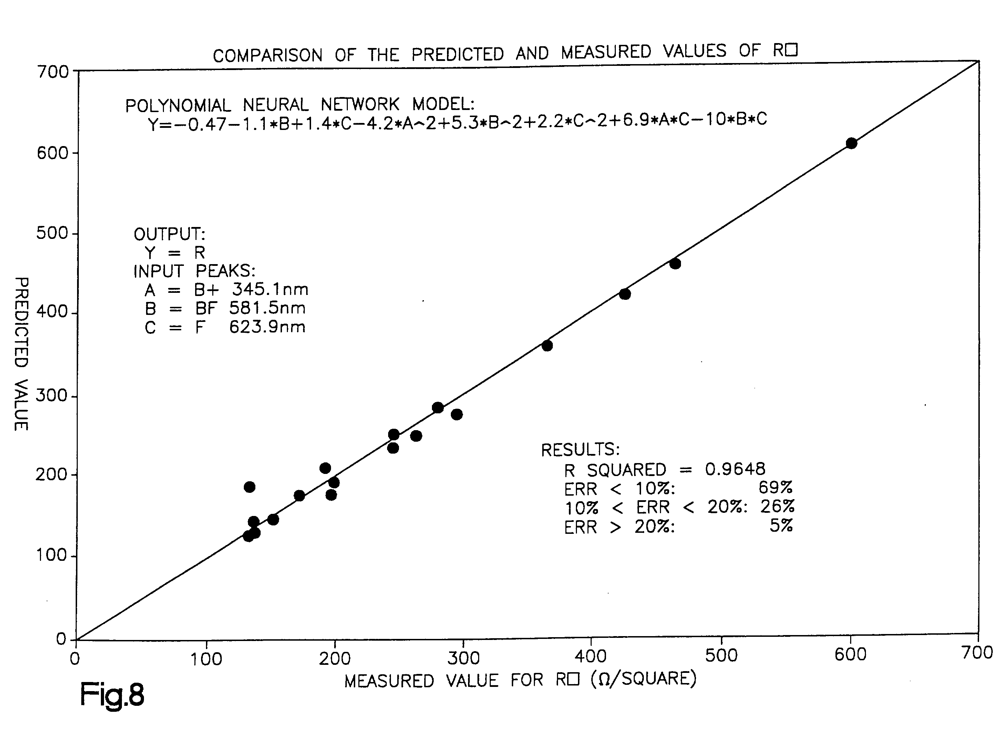

A preferred computer program that performs the analysis uses techniques such as back-propagation, simulated annealing or genetic algorithms for the neural network training. Figure 8 is a graph of measured versus predicted or projected values 300 of wafer resistivity. Agreement between measured and predicted resistivity for a measurement places the data on the diagonal line that extends away from the origin. Referring to Figure 7, one has spectral peaks at 345.1nm, 581.5nm, and 623.9 nm for B+, BF, and F respectively. The spectral intensity at these three points are treated as variables and a polynomial neural network model is derived based upon measured resistivity. Readings are sampled over may implants and a database created. A polynomial of the form Y = C1 + C2A + C3B + ... is evaluated where Y is the resistivity, the constants C1, C2, C3 etc are unknowns and A is the B+ intensity, B is the BF intensity and C is the F intensity are evaluated for many data samples. Solving for the constants yields a polynomial equation that is used to predict resistivity based upon measured parameters. The graph of Figure 8 indicates a good correlation of measured and predicted values based on data stored in the database. In one series of data gatherings the predicted value of resistivity was less than ten percent from the actual measured value for 69% of the readings. While the present invention has been described with a degree of particularity, it is the intent that the invention include all modifications and alterations from the disclosed design falling within the spirit or scope of the pending claims.

## Claims

1. A method for use in calibrating an ion implantation process comprising the steps of:
a) producing a concentration of ions in an ion source chamber (12, 220);
b) performing an optical analysis of the concentration of ions and recording optical analysis data;
c) treating one or more workpieces (14) by causing ions from the concentration of ions in the ion source chamber to impact the one or more workpieces;
d) evaluating a workpiece treatment parameter after ion treatment of said one or more workpieces; and
e) storing a database (280) of records on a storage medium wherein the workpiece treatment parameter and the optical analysis data for a given concentration of ions are stored together for subsequent access.

2. The method of claim 1 further comprising the step of forming an ion beam (228) from the concentration of ions in the source chamber and causing the beam to impact the one or more workpieces while performing optical analysis of the ions used to form the ion beam.

3. The method of claim 1 additionally comprising the step of adjusting the concentration of ions within the source chamber based upon the optical analysis data stored on the database of records to achieve a workpiece treatment result.

4. The method of claim 1 wherein the step of performing an optical analysis yields a series of intensity data values characterizing particle makeup within the ion source chamber.

5. The method of claim 4 wherein the intensity data values for different constituent particles are a function of emitted light wavelength.

6. The method of claim 1 wherein the step of producing a concentration of ions is performed by routing an ionizable gas into the ion chamber source chamber (12, 220) and wherein the step of performing the optical analysis is performed for different concentrations of the ionizable gas.

7. The method of claim 1 wherein the concentration of ions is created by injecting a gas into the ion source chamber (12, 220) and further comprising the step of controlling subsequent ion treatment of a workpiece by adjusting the rate at which gas is injected into the ion source chamber based upon data records stored on the database (280).

8. The method of claim 1 additionally comprising the step of using the data in the database (280) to produce a computer program that uses an input parameter optical emission spectra data from an ion plasma source to predict an output ion implantation parameter.

9. The method of claim 8 wherein the computer program uses an optimization technique to derive a relation between the sensed input of optical emission spectra data and the output ion implantation parameter.

10. The method of claim 8 wherein the workpiece is a silicon wafer and the output ion implantation parameter is suitability for subsequent processing of the wafer.

11. A method for use in ion implantation of a workpiece by building a database (280) regarding an ion plasma used to perform the ion implantation comprising the steps of:
a) providing a plasma of ions within an ion source chamber (220);
b) causing ions from the plasma to be emitted from the source chamber (220) and move away from the ion source chamber along an ion travel path (228) to an ion implantation chamber (216);
c) performing an optical analysis of an ion plasma within the ion source chamber (220) and recording optical analysis data;
d) recording one or more implantation parameters as ions from the source chamber impact one or more workpieces positioned within the implantation chamber for treatment by ions from the source chamber; and
e) creating a database (280) of plasma characteristics based upon optical analysis data from the plasma of ions in the ion source chamber and the one or more implantation parameters and storing the database on a data storage device.

12. An ion implantation system (10) for causing ions to impact an implantation surface of one or more workpieces comprising:
a) a process chamber (12) defining a chamber interior into which one or more workpieces (14) can be inserted for ion treatment;
b) an energy source (40) for setting up an ion plasma within the process chamber;
c) an optical sensor (270) for monitoring the ion plasma and for providing optical analysis data; and
d) a data store (280) for storing data correlating optical analysis data obtained from the optical sensor (270) with a parameter of workpiece treated by ions from the ion plasma.

13. The implantation system of claim 12 additionally comprising a programmable controller (274) for performing an analysis on data gathered from the optical sensor for use in adjusting a parameter of the plasma.

14. The implantation system of claim 12 additionally comprising a gas source (44) and wherein the parameter that is adjusted based upon the optical sensor output is a concentration of gas within the process chamber.

15. The implantation system of claim 12 additionally comprising a support (30) for positioning one or more workpieces within an interior region of the process chamber (12) so that an implantation surface of the one or more workpieces faces the source (40) for causing the ions to impact the implantation surface.

16. The implantation system of claim 12 additionally comprising an implantation controller (274) for adjusting ion implantation of a workpiece based upon the optical sensing of the ions.

17. An ion implantation system for causing ions to impact an implantation surface of one or more workpieces comprising:
a) a process chamber (12, 220) defining a chamber interior into which ion source material is added;
b) an energy source for setting up an ion plasma within the process chamber by ionizing the ion source material;
c) an optical sensor (270) for monitoring the ion plasma and for providing optical analysis data; and
d) a programmable controller (232, 274) for correlating optical analysis data obtained from the optical sensor (270) with a parameter of the constituents within the process chamber.
